# EUROPEAN PATENT APPLICATION

(11) **EP 4 636 444 A1**
(43) Date of publication of application: **22.10.2025**
(21) Application number: 24170403.0
(22) Date of filing: 16.04.2024
(51) Int. Cl.: G02B 5/20, G02B 5/22, G02B 5/28, G03F 7/00

(54) **RADIATION FILTER**

(71) Applicant: ASML Netherlands B.V., 5500 AH Veldhoven (NL)
(72) Inventor: CRAMER, Hugo Augustinus Joseph, 5500 AH Veldhoven (NL); HOUWELING, Zomer Silvester, 5500 AH Veldhoven (NL)
(74) Representative: ASML Netherlands B.V.

(57) **Abstract**

A radiation filter configured to filter a radiation beam comprising a plurality of wavelengths. The filter comprises a first material and a second material. The second material has a higher transmission for a first wavelength radiation than the first material. The second material is configured to change a phase of the first wavelength radiation. The first material and second material are arranged in a lateral distribution along a surface of the filter, and such that the first wavelength radiation transmitted through the first material and first wavelength radiation transmitted through the second material interfere destructively.

## Description

### FIELD

The present invention relates to filters for radiation. Specifically, it relates to filters comprising a plurality of materials arranged in a distribution configured to have a wavelength-specific transmission profile.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation, also referred to as drive radiation (e.g., infrared IR radiation) to excite a generating medium, thereby generating an emitted radiation, optionally a high harmonic generation comprising high frequency radiation.

In short wavelength metrology, the short wavelength radiation may be used to measure small features, for example lithographically patterned structures of semiconductor devices, or test structures patterned during manufacturing. The short wavelength radiation may be generated from longer wavelength radiation, for example through a process such as high harmonic generation. In a high harmonic generation process a high intensity drive laser may be led through a gas. The gas may have properties that cause it to have a nonlinear interaction with the drive radiation at high intensities, such that higher harmonics of the drive radiation are generated. This may result in the beam of radiation that has a series of intensity peaks in a short wavelength radiation regime. This short wavelength radiation can be used for metrology purposes. As not all of the drive radiation is converted into short wavelength radiation, steps may be taken to remove excess drive radiation from the short wavelength radiation beam.

### SUMMARY

According to an aspect of the current disclosure there is provided a radiation filter configured to filter a radiation beam comprising a plurality of wavelengths. The filter comprises a first material and a second material. The second material has a higher transmission for a first wavelength radiation than the first material, and the second material is configured to change a phase of the first wavelength radiation. The first material and second material are arranged in a lateral distribution along a surface of the filter, and such that the first wavelength radiation transmitted through the first material and first wavelength radiation transmitted through the second material interfere destructively.

Optionally, the first material may have a higher transmission for a second wavelength radiation than for the first wavelength radiation.

Optionally, the first material may have a first thickness and the second material has a second thickness. The thickness of the second material may be such that the phase change introduced in the first wavelength radiation is an odd multiple of π compared to the phase of the first wavelength radiation transmitted through the first material.

Optionally, the first material may cover a first portion P1 of the surface of the filter and may have a first transmission TD1 for the first wavelength radiation. The second material may cover a second portion P2 of the surface of the filter and may have a second transmission TD2 for the first wavelength radiation. The portions and transmissions may be such that the ratio of the first and second portions is approximately equal to the ratio of second and first transmissions P1/P2 ≅ TD2/TD1.

Optionally, the first transmission TD1 of the first material may be 50% or less.

Optionally, the first material may cover at least 50% of the surface of the filter.

Optionally, the lateral distribution may comprise a periodic distribution of the first material and the second material.

Optionally, the first material and second material may be arranged in a 1D periodic repeating pattern along the surface of the filter.

Optionally, the 1D periodic repeating pattern may comprise alternating strips of the first material and the second material.

Optionally, the first material and the second material may be arranged in a 2D repeating pattern across the surface of the filter.

Optionally, the 2D repeating pattern may comprise a connected web formed from the second material wherein gaps within the web are filled with the first material.

Optionally, the 2D repeating pattern may comprise a plurality of columns of second material filling holes in a layer of first material.

Optionally, the lateral distribution may be configured such that rays of radiation incident on the filter are transmitted either through the first material or through the second material.

Optionally, the first material and the second material do not overlap along a surface of the filter.

Optionally, the first material may cover a first portion of the surface of the filter in a range of 70% - 95%, or in a range of 75% - 90% of the surface of the filter.

Optionally, the first wavelength radiation may comprise one or more wavelengths in a range of 200 nm to 3000 nm, and optionally one or more wavelengths in a range of 500 nm to 1500 nm, and optionally a wavelength of 1030 nm.

Optionally, the second radiation may be generated from the first wavelength radiation through high harmonic generation.

Optionally, the second wavelength radiation may comprise one or more wavelengths in a range of 0.1 nm - 20 nm, or in a range of 6 nm to 25 nm, or in a range of 9 nm to 18 nm.

Optionally, the first material may comprise zirconium Zr.

Optionally, the first material may comprise a plurality of layers.

Optionally, the first material may comprise a layer of at least one of silver Ag, gold Au, aluminium Al, or copper Cu. The layer may have a thickness in a range of 5 nm to 20 nm.

Optionally, the first material may comprise a layer of at least one of zirconium Zr or graphite.

Optionally, the second material may have a higher refractive index for the first wavelength radiation than the first material.

Optionally, the second material may comprise at least one or Germanium Ge, or Silicon dioxide SiO2.

Optionally, the second material may have an anti-reflection coating provided on a surface exposed to incident radiation.

Optionally, the first material may have a transmission of at least 0.25 for the second wavelength radiation.

Optionally, the first material may have a transmission in a range of 0.5 or less for the first wavelength radiation.

Optionally, the filter may have a transmission in a rage of 10-3 or less, for the first wavelength radiation, or in a range of 10-5 or less for the first wavelength radiation.

Optionally, the filter may comprise a plurality of second materials.

Optionally, the filter may be configured to receive radiation at an oblique angle of incidence.

Optionally, the angle of incidence of the radiation may be in a range of 1 - 10 degrees from perpendicular to the surface of the filter.

According to another aspect of the current disclosure, there is provided a radiation filter configured to filter a radiation beam comprising a plurality of wavelengths. The filter comprises a first material and a second material. The second material has a higher transmission for a first wavelength radiation than the second material.

Optionally, the first material and the second material may be spatially arranged such that rays of the radiation incident on the filter is configured to be transmitted through both materials.

Optionally, the first material and the second material may be arranged in a vertical stack.

Optionally, the radiation filter may further comprise a third material.

Optionally, the filter may be a Salisbury screen.

Optionally, the first material may be zirconium.

Optionally, the second material may be germanium.

Optionally, the third material may be carbon.

Optionally, the carbon may be graphite or amorphous carbon.

Optionally, the third material may be manganese.

Optionally, the first wavelength radiation may comprise a wavelength of 1 µm, or one or more wavelengths in a range of 200 nm to 3000 nm, or optionally one or more wavelengths in a range of 500 nm to 1500 nm, or optionally a wavelength of 1030 nm.

Optionally, the second wavelength radiation may comprise one or more wavelengths in a range of 5 nm to 20 nm

According to another aspect of the current disclosure, there is provided a radiation source comprising a filter as described above.

According to another aspect of the current disclosure, there is provided a metrology apparatus comprising a radiation source as described above.

According to another aspect of the current disclosure, there is provided an inspection apparatus comprising a radiation source as described above.

According to another aspect of the current disclosure, there is provided a lithography apparatus comprising a radiation source as described above.

According to another aspect of the current disclosure, there is provided a lithography apparatus comprising a filter as described above.

According to another aspect of the current disclosure, there is provided a litho cell comprising an apparatus comprising a radiation source as described above.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of a radiation filter comprising a lateral distribution of a first material and a second material;
- Figures 9(a), 9(b), and 9(c) depict schematic representations of example periodic repeating patterns for lateral distributions of a first material and a second material of a filter;
- Figures 10(a) - 10(f) depict example graphs of transmission of first radiation and second radiation through a filter having specific lateral distribution designs;
- Figure 11 depicts a schematic representation of a radiation filter comprising a vertical stack of a plurality of materials; and
- Figure 12 depicts a lithographic system comprising a lithographic apparatus and the radiation source.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

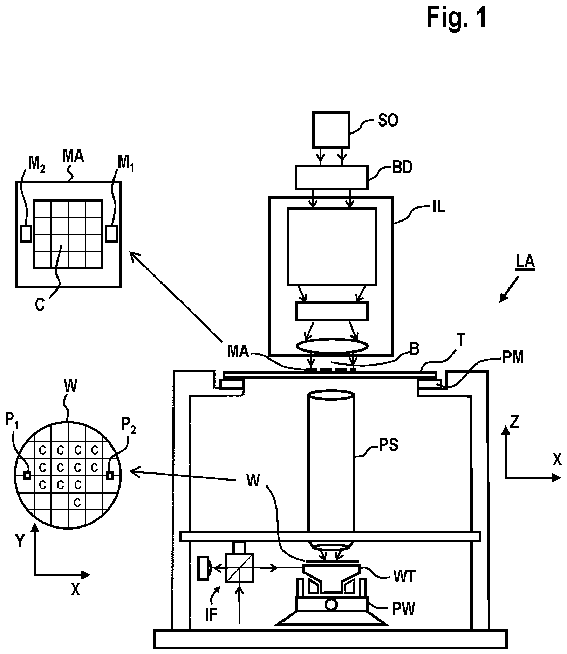

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

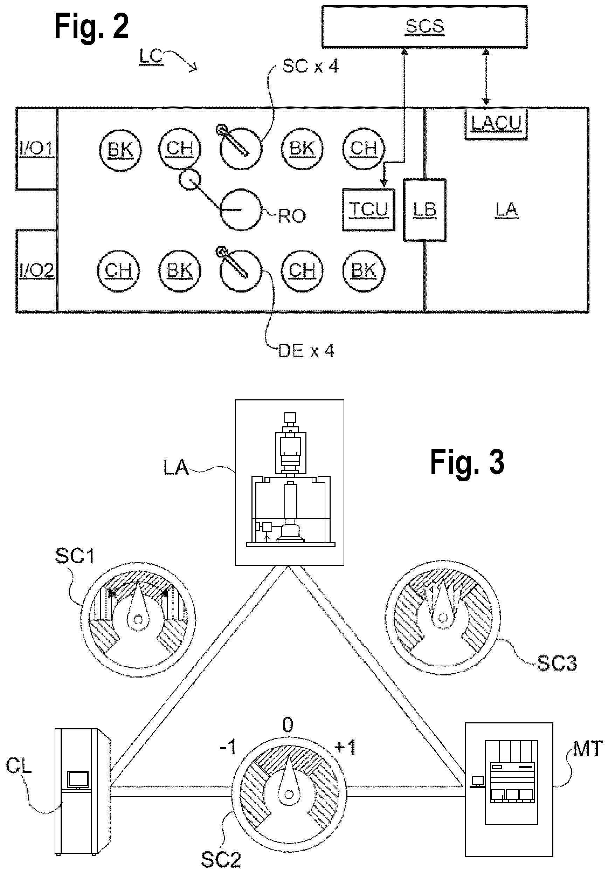

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

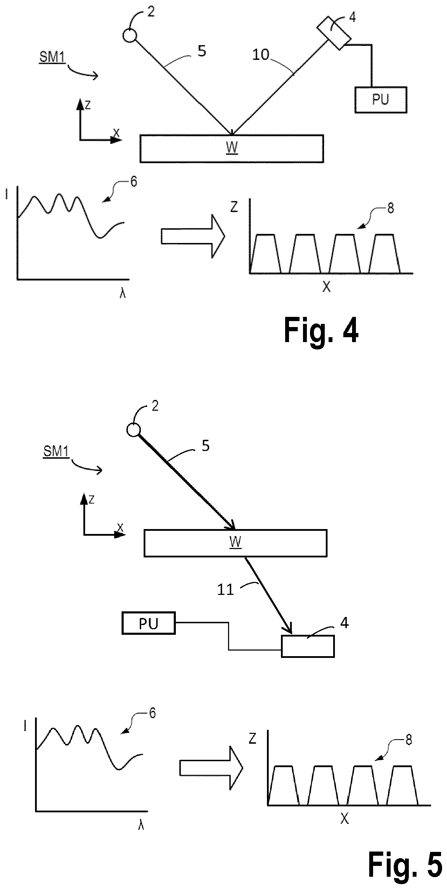

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

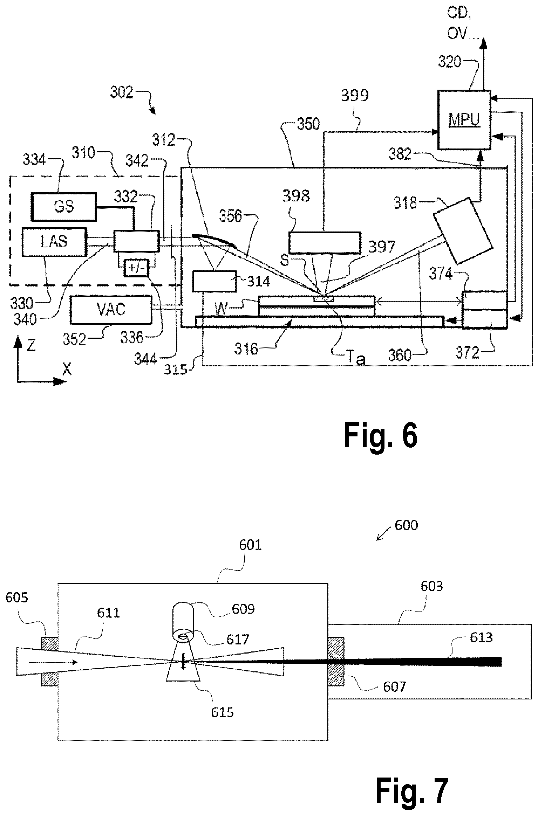

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

High harmonic generation described herein may be used in a metrology apparatus. The metrology apparatus may be used for the metrology of a lithographic substrate. The metrology apparatus may for example perform measurements to determine one or more parameters of a lithographically patterned structure on a substrate. As the dimensions of the structure may be small, the metrology apparatus may use short wavelength radiation able to resolve the size of the small structures. The metrology apparatus may further include one or more detectors to detect short wavelength radiation after has interacted with a structure to be measured. The short wavelength radiation to be detected may for example be radiation diffracted or scattered by a structure. The detectors may be sensitive to the short wavelength radiation, and any additional radiation that reaches the detectors may be detrimental to the quality of the resulting measurement. This may include any drive wavelength radiation that has not been filtered from the radiation beam. Removing this drive wavelength radiation before it reaches a detector is desirable for achieving a high quality measurement.

The conversion from drive radiation to short wavelength radiation can be inefficient. High intensities of drive radiation may be required to achieve significant nonlinear interactions of the drive radiation with a gas used for high harmonic generation. In an example implementation of HHG, a conversion efficiency of the order of 10⁻⁸ may be achieved. As a result the intensity of the drive radiation beam provided in the source may be several orders of magnitude higher than that of the resulting short wavelength radiation beam. The drive radiation is unwanted in the output from the radiation source, including being unwanted in a short wavelength metrology application. Therefore, the drive radiation may be suppressed. In existing setups this may be achieved partially in the source, for example by a combination of design of the shape of the drive radiation beam and the use of one or more apertures, to spatially separate the drive radiation from the generated short wavelength radiation. Suppression of the drive radiation may further be achieved by placing one or more absorbing membranes at different locations along the propagation path of the radiation beam. The absorbing membranes (which may also be referred to as filters) may have strong absorption for drive wavelength radiation, and high transparency for short wavelength radiation, for example zirconium Zr. Zirconium has a desirable property of being strongly absorbent in the infrared range of the spectrum, while having reasonably high transparency for the short wavelength range of the spectrum (e.g. 1 nm - 20 nm). Reasonably high transparency may be understood to mean a transparency that is high compared to other materials which are strongly absorbent in the infrared range of the spectrum. Alternatively to zirconium, graphite may be provided as an example first material. In some instances, reflection may be used additionally or alternatively to absorption to remove radiation wavelengths from a beam.

A disadvantage of using a filter for drive radiation suppression may be that the filtering material still absorbs a significant amount of the short wavelength radiation. For example, to achieve sufficient suppression of infrared drive radiation, a thickness of several hundred nanometres of zirconium material may be required. For example, a zirconium membrane with a 200 nm thickness may suppress infrared radiation by a factor of the order of 10⁻⁵ (e.g. using a thin film calculation with a refractive index of n = 4.646 - 3.8446i for the drive wavelength). However, a zirconium filter of this thickness may have a transmission for short wavelength radiation in a range of 0.1 to 0.5. Described herein are improved systems and methods for filtering out drive wavelength radiation.

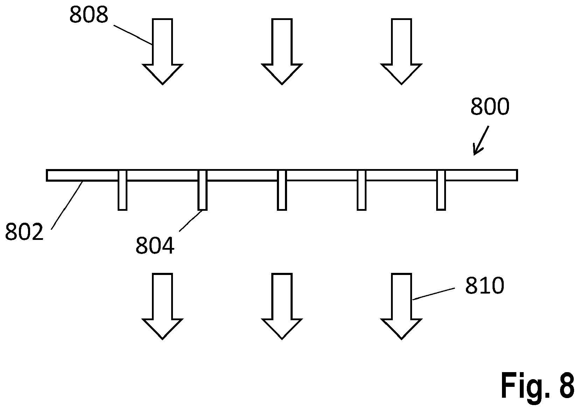

Figure 8 depicts a schematic representation of a radiation filter 800 for filtering radiation 808. Radiation 808 comprises a plurality of wavelengths, including first wavelength radiation and second wavelength radiation. The first wavelength may be longer than the second wavelength. The filter 800 comprises a first material 802 and a second material 804. The second material 804 has a higher transmission for the first wavelength than the first material 802. The second material 804 is configured to change the phase of the first wavelength radiation. The first material 802 and the second material 804 are arranged in a lateral distribution along a surface of the filter. This surface may be the surface on which the radiation 808 is configured to be incident, or it may be the opposite surface to the surface on which the radiation in configured to be incident. The lateral distribution is designed such that the first wavelength radiation transmitted through the first material 802 and the first wavelength radiation transmitted through the second material 804 interfere destructively. The destructive interference may be achieved by the first and second materials introducing a first and second phase change, respectively, wherein the difference between the first phase change and the second phase change is an odd multiple of π.

An advantage of the filter described above is that it uses destructive interference to remove first radiation that has been transmitted through the filter. Substantially complete suppression of first radiation may be obtained by the filter when the amount of first radiation transmitted through the first material and the amount of radiation transmitted through the second material are substantially equal. How this can be achieved is described in more detail below. The phase change introduced by the second material may be proportional to the thickness of the layer. The phase change may also be proportional to the refractive index n of the material, or a function of the refractive index of the second material such as (n-1). By making use of dispersive properties of the first material and the second material, the destructive interference (through an odd number of π phase difference) can be achieved for the first wavelength, while not being present for the second wavelength. As a result, the second wavelength radiation transmitted through the first material may be interfere non-destructively with any second wavelength radiation transmitted through the second material.

The first wavelength radiation may also be referred to as first radiation. The second wavelength radiation may also be referred to as second radiation. The first radiation may have a longer wavelength than the second radiation. The first radiation may therefore also be referred to as long wavelength radiation, and the second radiation may also be referred to as short wavelength radiation. The radiation 808 may comprise high harmonic generated (HHG) radiation, generated through non-linear interaction of high intensity drive radiation with a gas. The first radiation may comprise for example drive radiation, while the second radiation may comprise HHG radiation.

The short wavelength radiation may comprise one or more wavelengths in a range of 0.1 nm - 20 nm, for example in a range of 6 nm to 25 nm, or in a range of 9 nm to 18 nm. The long wavelength radiation may comprise radiation for example in a range from 200 nm to 3000 nm. For example the long wavelength radiation may comprise one or more wavelengths in a range from 500 nm to 1500 nm, or for example in the range of 950 nm to 1100 nm. The long wavelength radiation may comprise infrared radiation. The long wavelength radiation may comprise radiation from a high intensity radiation source, which may have a specific wavelength, for example 1030 nm, or 1033 nm.

While blocking first radiation, the filter may also be configured to have good transmission of the second radiation. Transmission of second radiation may be dominated by transmission through the first material. The amount of second radiation transmitted through the second material may be negligible compared to the amount transmitted through the first material. Therefore, the amount of second radiation transmitted through the filter may be approximately equal to the relative lateral area of the filter occupied by the first material times the transmission of the first material. This may be a motivation to keep the thickness of the first material low, to achieve a higher transmission for the second wavelength (compared to a thicker first material layer).

Referring to the radiation filter 800, the first material 802 may have a higher transmission for the second radiation than for the first radiation. The relative lateral area (i.e. portion of the surface of the filter on which radiation is configured to be incident) occupied by the first material may be significantly higher than the relative lateral area occupied by the second material, for achieving good transmission of second radiation. The first material 802 may cover at least 50% of the surface of the filter on which radiation 808 is configured to be incident. The first material covers less than 100% of the surface of the filter. In some instances the first material 802 may cover at least 70% of the surface of the filter, for example in a range of 70% to 95%, or in a range of 75% to 90% of the filter 800 on which radiation 808 is configured to be incident. An advantage of having at least half of the surface of the filter on which radiation is configured to be incident to have a higher transmission for the second radiation than for the first radiation, is that the filter is relatively more transparent to the second radiation. The filter may be used to filter first radiation out of radiation 808 obtaining a filtered radiation 810. By having a higher transmission for the second radiation, the filter can be used to block first radiation while transmitting second radiation.

The first material my comprise zirconium Zr. Zirconium may be chosen as a material as it has the desired transmissive properties for long wavelength first radiation and short wavelength second radiation. Zirconium may have lower transmission for e.g. infrared radiation, and a comparatively higher transmission for HHG radiation e.g. in the 9 nm - 18 nm range. An advantage of zirconium as a first material for the wavelength range as described above may therefore be the achieved a significant suppression of the first radiation while having a high transmission of second radiation. In order to achieve a high transmission of second radiation, which may comprise very short wavelengths (e.g. in the range of 9 nm to 18 nm), the layer of first material may be thin, for example in the order of 50 nm or less, such as for example in a range of 15 nm to 50 nm.

The second material may comprise one or more of Germanium Ge or Silicon Dioxide SiO2. The second material may have a higher refractive index for the first wavelength than the first material. A higher refractive index may introduce a larger phase shift compared to a lower refractive index when radiation propagates through the material. Therefore, a phase shift of π (3π, 5π, etc.) may be introduced along a shorter propagation length compared to a material with a lower refractive index. However, material with a high refractive index may reflect first radiation incident on its surface, which may be an unwanted side effect. The second material may have significantly higher transmission of the first radiation compared to the first material. The thickness and refractive index of the second material in the lateral distribution may be selected such that a phase shift of an odd multiple of π is introduced by the material compared to the phase shift introduced by the first material.

The lateral distribution described in relation to Figure 8 can be understood to mean distribution across the surface of the filter of areas comprising either first material or second material. The first material and the second material may be non-overlapping across the surface of the filter. The lateral distribution of the first and second materials may be such that rays of radiation incident and transmitted through the filter pass either through the first material or through the second material, but not through both. This is a classical interpretation of radiation interacting with the filter described herein. When considering particle-based diffraction behaviour, a small portion of photons may travel through both materials. However, the amount photons exhibiting this behaviour is small enough to be negligible for the purposes of systems and methods described herein.

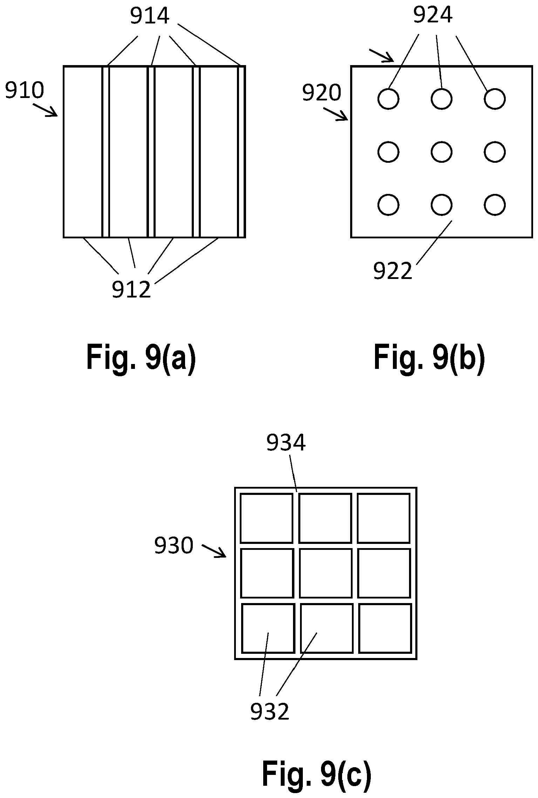

The lateral distribution may comprise periodic distribution of the first material and the second material. In some implementations, the periodic distribution may for example comprise an arrangement of a one-dimensional (1D) periodic repeating pattern along the surface of the filter. While the lateral distribution may be across a two-dimensional surface, the repeating pattern may be along one (single) dimension. Figure 9(a) depicts a schematic representation of a top view of an example 1D periodic repeating pattern on the surface of a filter 910. The periodic pattern forming the lateral distribution across the surface of the filter may comprise alternating strips of the first material 912 and the second material 914.

In some implementations, the lateral distribution may comprise for example an arrangement of a two-dimensional (2D) periodic repeating pattern along the surface of the filter. In this case, a pattern may be repeated in a first direction as well as a second direction of the surface of the filter. The pitch along the first repeating direction and the second repeating direction may be identical, or may be different. Figure 9(b) depicts a schematic representation of a top view of an example 2D periodic repeating pattern on the surface of the filter 920. The 2D repeating pattern may comprise a connected web formed of first material 922, comprising holes. The holes may be filled with second material 924. The second material may columns 924. In another example a top view of a filter 930 is depicted in figure 9(c). The filter 930 may have a 2D periodic repeating pattern formed from a connected web of second material 934. Gaps within the web may be filled with first material 932.

It should be noted that edges between the first material and the second material may introduce scattering of radiation incident upon the filter. The edges may be vertical edges, wherein vertical means an edge perpendicular to the surface of the filter. These scattering effects may be neglected, providing an approximation, the results of which may hold when the pitch of the periodic repeating pattern is significantly larger than the wavelength. Specifically, the periodic repeating patterns described herein may have a pitch (size of the repeating structure) that is significantly larger than the first wavelength. Significantly larger may for example name at least twice as long as the longest wavelength in the first radiation. For example, for first radiation with a wavelength of 1030 nm, a periodic repeating pattern with a period in a range of 2 - 3 µm, or greater may be considered.

Further to the lateral distribution of the first material and the second material, the design and functionality of the filter may also be determined by the thickness of the materials. The first material may have a first thickness and the second material may have a second thickness across the surface of the filter. The thickness of the first material may be substantially equal across the surface of the filter. The thickness of the second material may be substantially equal across the surface of the filter. The thickness of the second material may be chosen such that the phase change introduced in the first radiation is an odd multiple of π compared to the phase of the first radiation transmitted through the first material. Because of dispersion and transmissive properties of the first and second materials, this destructive interference is not obtained for the second radiation. An advantage of the filter described herein may therefore be that first radiation interferes destructively, while second radiation does not interfere destructively.

Due to the difference in thickness of the first material and the second material across the surface of the filter, it follows that at least one side of the surface of the filter is not planar. In some implementations, neither side of the filter has a planar surface, due to a difference in thickness of the first material and the second material. In some implementations, the surface of the filter may be substantially planar on one side of the filter. The planar side may be the side on which the radiation is configured to be incident. This may be achieved by aligning the top of the first material and the top of the second material to form the surface of the filter. In some implementations, the planar side may be at the side where transmitted radiation exits the filter.

In some implementations the second material may have an anti-reflection coating provided on the surface of the second material that is exposed to incident radiation. The anti-reflection coating may be tuned to avoid reflection of first radiation. In some implementations, the filter may comprise a plurality of second materials. For example, a filter may comprise both germanium and silicon dioxide as second materials.

In some implementations, the filter may be configured to receive radiation at the perpendicular angle of incidence, wherein perpendicular may mean at a straight angle to the surface of the filter. In some implementations, the filter may be configured to receive radiation at an oblique angle of incidence. The oblique angle may for example be in a range of 1° - 10° from perpendicular to the surface of the filter.

As stated above, the lateral distribution and the respective thicknesses of the first material in the second material may be selected as part of the design of the filter. The first material may cover a first portion P1 of the surface of the filter and may have a first transmission TD1 for the first radiation. The second material may cover a second portion P2 of the surface of the filter and may have a second transmission TD2 for the first radiation. Properties P1, TD1, P2, and TD2 of the materials and lateral distribution design may be predetermined such that the ratio of the first and second portions is substantially (or approximately) equal to the ratio of the second and first transmissions: P1/P2 ≅ TD2/TD1. This may be because the amount of transmitted light through the first material may be expressed as P1*TD1, and the amount of transmitted light through the second material may be expressed as P2*TD2. If these amounts are approximately/substantially equal, and they have a π phase difference between the approximately/substantially equal amounts, this may lead to destructive interference of approximately/substantially all transmitted first radiation. The resulting transmission of the first radiation through the filter may be in a range of 10⁻³ or less, or in a range of 10⁻⁵ or less for the first radiation.TD1 may be 50% or less. The transmissions TD1 and TD2 represent values for the first radiation. The first material may have a transmission for the second wavelength radiation TD'1 of at least 0.25. The second material may have a transmission for the second wavelength radiation TD'2 that is low enough to have no significant impact on the function of the filter.

In an example implementation, a filter as described in relation to Figure 8 may be provided for filtering long wavelength radiation from a radiation beam comprising both long wavelength radiation and short wavelength radiation. In an example implementation the short wavelength radiation may be high harmonic generated radiation generated from long wavelength drive radiation. The filter may comprise a plurality of materials, including a first material (material A) and the second material (material B). The first material and the second material may be distributed across the surface of the filter in a lateral distribution (e.g. as described in relation to figure 9). Material A and Material B may be non-overlapping across the surface of the filter. Material A may suppress the long wavelength radiation, for example by having a transmission in a range of 0.2 or less for the long wavelength radiation. Material A may have a high transmission for the short wavelength radiation. For example material A may have a transmission in a range of 0.5 or more over the whole of the short wavelength range comprised in the radiation. Material B may have a significantly higher transmission of the long wavelength radiation. The thickness of material B may be greater so as to introduce a greater phase shift in the long wavelength radiation. By selecting material A to cover a predetermined larger proportion of the filter surface than material B, while having a lower transmission than material B, the resulting amount of long wavelength radiation transmitted through material A and material B may be substantially equal. By selecting the thicknesses of material A and material B to introduce respective phase changes to the long wavelength radiation that differ from each other by an odd number of π, destructive interference of substantially all long wavelength radiation transmitted through the filter surface may be achieved.

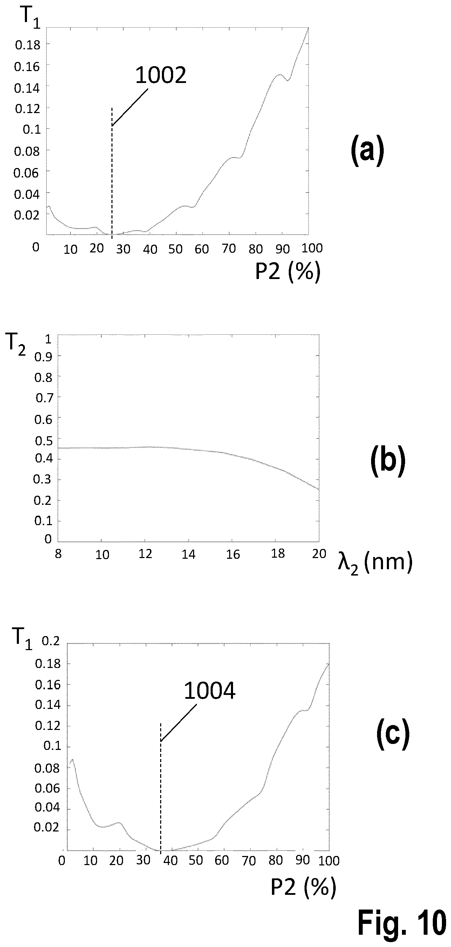

In a first example, a filter may be provided with zirconium Zr as first material and germanium Ge as second material. The Zr/Ge lateral structure may a pitch of 2500 nm, and comprise 50 nm thick Zr layer as first material, with a 225 nm thick Ge layer as second material. A lateral distribution may be selected at which destructive interference of first radiation (e.g. 1030 nm) may be expected. This may for example be achieved with a lateral distribution consisting of strips of Ge with a width of 625 nm, and strips of Zr with a width of 1875 nm in a 1D periodic pattern covering the surface of the filter. Figure 10(a) depicts an example graph of a simulation where the transmission of first radiation T₁ by the filter is determined for a 50 nm Zr thickness layer, a 225 nm thick Ge layer, and a 2500 nm pitch. The portion P2 of the surface of the filter covered by Ge is varied along the x-axis. The percentage 1002 for which the transmission T₁ reaches its lowest value may be selected for the lateral distribution design. The lowest value for T₁ depicted in figure 10(a) may have a value of approximately 5.1 10⁻⁶. Figure 10(b) depicts transmission T₂ for different wavelengths λ₂ of the second radiation by the filter for the selected lateral distribution filter design of figure 10(a).

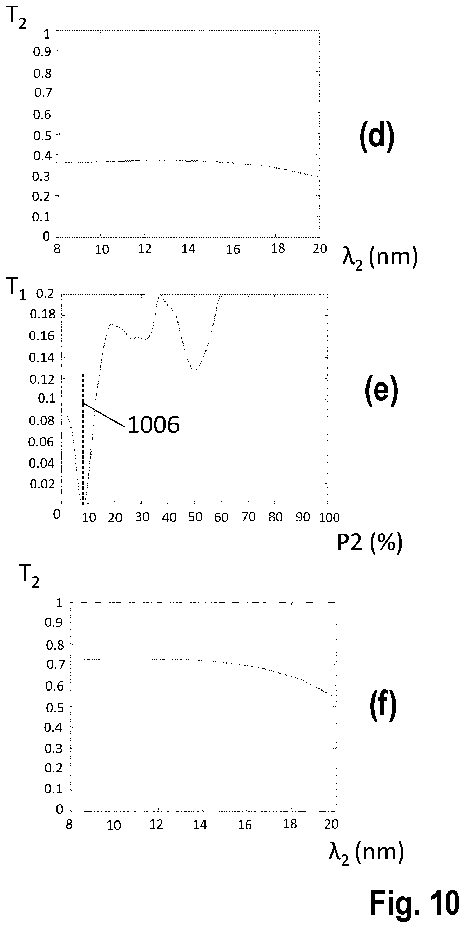

In a second example, a thinner zirconium layer of 25 nm is provided, with the same pitch of 2500 nm as the first example. The associated Ge layer to achieve destructive interference for first radiation (e.g. at 1030 nm) may have a thickness of 175 nm. A thinner layer of Zr may transmit more second radiation. However, a thinner Zr layer may also lead to more first radiation transmission, meaning a larger portion of the surface of the filter may be covered by the Ge material (e.g. 925 nm Ge strips, compared to 625 nm in the first example). As Ge has very low/negligible transmission for second radiation, the resulting transmission of second radiation may be lower than for the first example. Figure 10(c) depicts an example graph of a simulation where the transmission of first radiation Tₗ by the filter is determined for a 25 nm Zr thickness layer, a 175 nm thick Ge layer, and a 2500 nm pitch. The portion P2 of the surface of the filter covered by Ge is varied along the x-axis. The percentage 1004 for which the transmission T₁ reaches its lowest value may be selected for the lateral distribution design. The lowest value for T₁ depicted in figure 10(a) may have a value of approximately 9.3 10⁻⁶. Figure 10(d) depicts transmission T₂ for different wavelengths λ₂ of the second radiation by the filter for the selected lateral distribution filter design of figure 10(a).

In a third example, silicon dioxide SiO₂ may be used as a second material. The refractive index of silicon dioxide is much lower than the refractive index of germanium for the wavelengths considered for first radiation. Therefore, the second material requires a larger thickness than germanium to achieve an equivalent π phase change. A 25nm thick zirconium layer is used as the first material. The pitch of the periodic pattern was increased to 3185 nm. This may be to achieve good interference for the zirconium-silicon dioxide filter design. A 225.2 nm wide SiO2 strip may be added to the 25 nm thick zirconium covering the rest of the surface. Figure 10(e) depicts an example graph of a simulation where the transmission of first radiation T₁ by the filter is determined for a 25 nm Zr thickness layer, a 3150 nm thick SiOz layer, and a 3185 nm pitch. The portion P2 of the surface of the filter covered by Ge is varied along the x-axis. The percentage 1006 for which the transmission T₁ reaches its lowest value may be selected for the lateral distribution design. The lowest value for T₁ depicted in figure 10(a) may have a value of approximately 1.9 10⁻⁵. Figure 10(f) depicts transmission T₂ for different wavelengths λ₂ of the second radiation by the filter for the selected lateral distribution filter design of figure 10(a).

Figure 10(f) indicates that using SiO₂ may achieve a higher overall second wavelength transmission T₂ than filters using germanium as a second material. However, the requirements on the design of the lateral distribution and differences in thickness between the Zr and SiO₂ layers may be more stringent (figure 10(e) shows a narrow minimum compared to 10(a) and 10(c)). The example filters described in relation to figure 10 are not exhaustive, and provided as examples for illustration purposes only. Other designs of lateral distribution and layer thickness may be considered for filters as described herein.

In some implementations, the first material may comprise a plurality of layers. The first material may for example comprise a layer of one or more of the following materials: silver Ag, Gold Au, aluminium Al, or copper Cu. the first material may be covered with a carbon film. A layer of one of these materials may for example have a thickness in a range of 5 nm to 20 nm. A layer of one of these materials may be used to reflect infrared radiation incident upon the layer. The thickness of the layer may be tuned alongside the refractive index of the material of the layer to reflect a specific wavelength of interest. For example for a wavelength of 1033 nm, 20 nm film of one of the materials listed above may lead to resulting transmission of 10% or less. However, the presence of such a layer may also affect the transmission of the second radiation. For wavelengths in a range of 8 nm to 20 nm, transmission may drop below 0.5. Therefore, a thinner layer than 20 nm may be considered.

The filter designs described herein using a lateral distribution of at least two materials may achieve a better suppression of first radiation while second radiation transmission may be significantly higher, compared to filters using only zirconium.

In some implementations, zirconium may have a thin layer of oxide deposited onto the surface of the material. The filter in a vacuum vessel, and the surface oxide may be deposited as a result of the interaction of incident radiation with impurities present inside the vessel. This oxidation may be an undesirable side effect of operation of the filter. Radiation incident upon the filter may have a high localised intensity, which may lead to a high temperature being generated at the surface of the filter on which radiation is incident. The oxidation of the filter surface may accelerate at increased operating temperatures. It may therefore be desirable to lower the operating temperature of the filter.

Lowering of the operating temperature of the filter may be achieved by reducing the amount of radiation being transmitted through the material of the filter. As the filter is configured to transmit second radiation, blocking first radiation from being transmitted through the filter may be desirable. Therefore, removing first radiation from the radiation beam incident upon the filter may be in part performed through processes involving reflection. Table 1 provides example transmissions for a first wavelength (1033 nm) and a second wavelength (13.5 nm) for different thicknesses of zirconium layer. The layer of zirconium may be provided on a 70 line per inch nickel Ni mesh. The transmission values of table 1 may be calculated or estimated values.

**Table 1 - transmission values for different zirconium layer thicknesses**

| Zr thickness [nm] | T₁₀₃₃ₙₘ [%] | T_{13.5nm} [%] |
|---|---|---|
| 100 | 2.8 10⁻¹ | 70.4 |
| 200 | 2.6 10⁻³ | 49.5 |
| 220 | 1.0 10⁻³ | 46.1 |
| 300 | 2.4 10⁻⁵ | 34.8 |
| 400 | 2.2 10⁻⁷ | 24.5 |
| 450 | 2.2 10⁻⁸ | 20.6 |
| 466 | 1.0 10⁻⁸ | 19.4 |

From table 1 it may be determined that for a 100 nm thick zirconium layer the transmission of an example first radiation wavelength (1033 nm) has a value of around 0.2. This amount of blocking may be insufficient, as described above. Table 1 further indicates that in order to achieve a level of transmission of the order of 10⁻⁸ (which may be considered to constitute blocking of the radiation), a layer of zirconium with a thickness of at least 466 nm may be required. This would lead to insufficient transmission of second radiation.

Proposed herein are filter designs for blocking first radiation and transmitting second radiation. The first radiation may be as described above. The first radiation may for example have a wavelength around 1 µm (e.g. 1033 nm). The second radiation may be as described above. The second radiation may for example have one or more wavelengths in the range of 5 nm to 20 nm. In order to achieve this performance, the filter may comprise a stack of a plurality of materials, each having specific refractive index properties and specific thicknesses. The stack may be a vertical stack of a plurality of materials. A vertical stack may mean that layers are placed such that incident radiation passes through the plurality of materials. Incident radiation may pass through each of the materials in the stack consecutively. The filter may be a Salisbury screen filter. The Salisbury screen filter may exhibit behaviour of absolute (~100%) absorption of first radiation at a selected wavelength. The selected wavelength may for example be (approximately) 1 µm. The stack of a plurality of materials may create a surface that is reflective for the selected wavelength. The thicknesses may be selected to exceed a six-fold skin depth value. This selection of thicknesses may ensure that the stack of layers is sufficiently thin to allow transmission of the second radiation. Such a filter may be referred to as an infrared spectral purity filter (IRSPF).

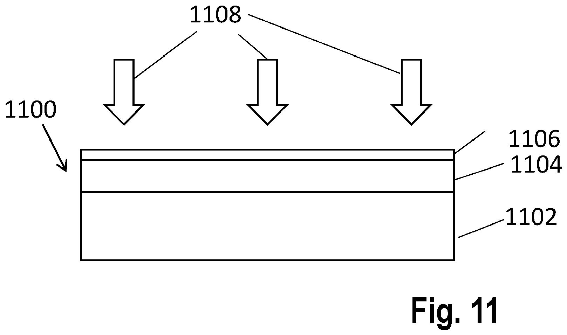

Figure 11 depicts a schematic representation of an example radiation filter 1100 as described herein. The radiation filter may be configured to filter an incident radiation beam 1108 comprising a plurality of wavelengths. The wavelengths may be as described for the first radiation in the second radiation above. The radiation filter 1100 may be referred to as a vertical stack filter. The filter 1100 may comprise a first material 1102 and a second material 1104. The second material 1104 may have a higher transmission for the first wavelength than the first material 1102. The first material 1102 and the second material 1104 may be spatially arranged such that a radiation beam 1108 incident upon the filter may pass through both materials. The radiation filter 1100 may comprise a third material 1106. The first 1102, second 1104, and third 1106 materials may also be referred to as first, second, and third layers, respectively. The third material 1106 may be the top layer. By top layer it may be understood that radiation is configured to be incident on the top material first, during normal operation of the radiation 1100.

The vertical stack of the filter may be designed to achieve several functions. A first function may be to have low membrane operating temperature. A second function may be to block radiation of a selected wavelength (1 µm). A third function may be to have a capacity to transmit second radiation photons.

A first example filter may have a vertical layer stack comprising a 200 nm thick zirconium layer, followed by 52 nm thick germanium layer, followed by a 27 nm thick carbon layer. The carbon may be graphite or an amorphous carbon. Alternatively to carbon, the first example filter may have a top layer of 1.5 nm thick yttrium Y with an oxidation-protective cap layer of 5 nm C. This example filter may have thermal emissivity in a range of 50% to 100% for wavelengths in a range of 3 µm to 5 µm. This example filter may have 0% transmission for a 1 µm wavelength radiation. This example filter may have 43.3% transmission for a 13.5 nm wavelength radiation. The vertical stack may achieve this performance by placing the carbon layer on the zirconium layer separated by the germanium dielectric layer, which achieve Salisbury screening for the desired 1 µm wavelength.

A second example filter may have a vertical stack comprising a zirconium layer with a thickness in a range of 120 nm to 200 nm, followed by a 52 nm germanium layer, followed by a 27 nm carbon layer. Alternatively to carbon, the second example filter may have a top layer of 1.5 nm yttrium Y with a cap layer of 5 nm carbon C. As for the first example above, the carbon may be graphite or an amorphous carbon. This example filter may have thermal emissivity in a range of 50% to 100% for wavelengths in a range of 3 µm to 5 µm. This example filter may have 0% transmission for a 1 µm wavelength radiation. This example filter may have 57.4% transmission for a 13.5 nm wavelength radiation.

A third example filter may have a vertical stack comprising a zirconium layer with a thickness in a range of 120 nm to 200 nm, followed by a 76 nm boron carbide B₄C layer, followed by a 27 nm carbon layer (graphite or amorphous carbon). Alternatively to carbon, the third example filter may have a top layer of 1.5 nm yttrium Y with a cap layer of 5 nm carbon C. This example filter may have 43.8% transmission for 13.5 nm wavelength radiation. A fourth example filter may have a vertical stack comprising a zirconium layer with a thickness in a range of 120 nm to 200 nm, followed by a 69 nm silicon Si layer, followed by a top layer of 1.5 nm yttrium Y with a cap layer of 5 nm carbon C. This example filter may have 56.2% transmission for 13.5 nm wavelength radiation. A fifth example filter may have a vertical stack comprising a zirconium layer with a thickness in a range of 120 nm to 200 nm, followed by a 89 nm selenium Se layer, followed by a top layer of 1.5 nm yttrium Y with a cap layer of 5 nm carbon C. This example filter may have 1.6% transmission for 13.5 nm wavelength radiation.

In the examples provided above the 1.5 nm Y layer with 5 nm C cap layer may be replaced by a 4.3 nm manganese Mn layer, or a 27 nm carbon C layer (amorphous or graphite), or a 1.1 nm zirconium Zr layer with 5nm carbon C cap layer Other materials that may be used in the vertical stack filter may include bismuth telluride Bi₂Te₃ of a thickness of 34 nm. Any of these absorbers in combination with a dielectric spacer and a zirconium mirror layer may give rise to Salisbury screening. However, absorber layers such as a 1.5 nm Y layer or a 1.1 nm Zr layer may be prone to oxidation. The cap layer may be used to cover and protect the absorber layer. The cap layer may for example be a thin layer of carbon. The thickness of the cap layer may be chosen to be as thin as possible while still forming a closed layer, e.g. 5 nm. In some instances a closed layer may be formed using a 4 nm thick carbon layer, or a 3 nm thick carbon layer. The cap layer may have a thickness in a range of 3 nm to 6 nm. Having a closed layer of carbon cover the Y or Zr absorber layer may prevent oxidation of the Y or Zr.

An advantage of the vertical stack filter described herein may be that it results in a flatter transmission of second radiation, for example in the 5 nm - 20 nm wavelength range. Flatter in this context may be interpreted as having a more constant transmission across the stated wavelength range. Another advantage of the vertical stack filter may be a lower operating temperature. This may be as a result of absorbing a portion of incident first radiation. The absorption of first radiation may result in a higher thermal emissivity. The thermal emissivity may be increased by a factor of up to 25. The temperature may be lower by one or more 100s of degrees Celsius.

If there is a concern that the bottom zirconium layer of the vertical stack filter described herein may oxidise, a thin carbon layer may be applied to the exposed side of the zirconium layer. This carbon layer may be applied without loss of function of the filter. Thin layer may in this instance mean a layer with a thickness in the range of 10 nm or less, for example 3 nm.

While the specific examples of vertical stack filters described herein are designed for blocking radiation with a wavelength of 1 µm while transmitting 5 nm - 20 nm wavelength, it will be understood that this design may be adapted for blocking and/or transmitting other wavelengths. This may be achieved through choosing either different thicknesses, and or selecting different materials to form part of the vertical stack.

The vertical stack filters described herein may be based on an arrangement of a nanolayer separated from a (perfect) mirror by a dielectric layer. The nanolayer may also be referred to as an absorber layer. The nanolayer may comprise a metal. For example, in the first example filter described above, the 200 nm zirconium layer may perform the function of a mirror, which may be approximated as a perfect mirror. The germanium layer may perform the function of the dielectric layer, and the 27 nm carbon layer may perform the function of the nanolayer. The vertical stack filters described herein may be adjusted by tuning the thicknesses and composition of the different layers. The thickness and/or conductivity (tuned by material choice) of the nanolayer and the thickness and refractive index (tuned by material choice) of the dielectric layer may be tuned to choose a wavelength of maximal reflection, transmission, or absorption, depending on the filter. By tuning the material and thickness choices to achieve perfect absorption at a specific wavelength, a Salisbury screen may be achieved.

The mirror layer may be approximated as having zero transmission. However, in order to block radiation transmission of a wavelength λ, the thickness of the mirror layer should exceed 6 times to skin depth value for wavelength λ. If this condition is met, the material may be considered opaque (i.e. have 0 transmission) for radiation of a wavelength λ. The skin depth may defined as δ_{λ} = λ/(4πκ:), where λ is the radiation wavelength and κ is the extinction coefficient. For example, for a wavelength of λ = 1 µm, the following values may arise: κ = 3.8 and δ₁ µm = 21 nm. A zirconium layer with a thickness of 200 nm is therefore 10x the calculated skin depth, meaning the zirconium layer is opaque at λ = 1 µm. This 1 µm wavelength may represent a radiation wavelength (i.e. first radiation) to be blocked by the filter assembly.

The properties of the nanolayer and the dielectric layer may then be chosen to enable transmission of second radiation. In the example filters described herein, the second radiation may include radiation with a wavelength of 13.5 nm. It is understood that other material choices and other layer thicknesses can be selected to tune the filter functionality to other wavelengths to be transmitted (second radiation) and/or blocked (first radiation). The absorber layer may be thin and provide thermal emissivity to cool the filter. Next to the specific first - fifth example filters described above, the following table sets out example combinations of material properties and thicknesses for absorber layers and dielectric layers:

**Table 2 - example filter dielectric material and absorber material configurations**

| Dielectric material | Refractive index | Thickness [nm] | Transmission (at 13.5 nm) | Absorber material | Thickness [nm] | Transmission (at 13.5 nm) |
|---|---|---|---|---|---|---|
| Si₃N₄ | 2.0 | 125 | 36.7 | C | 27 | 84 |
| Se | 2.8 | 89 | 31.1 | Mn | 4.3 | 87.7 |
| B₄C | 3.3 | 76 | 69.5 | Y | 1.5 | 99.5 |
| Si | 3.6 | 69 | 89.3 | Zr | 1.1 | 99.6 |
| Ge | 4.4 | 52 | 21.3 | C | 27 | 84 |
| Bi₂Te₃ | 7.4 | 34 | 12.0 | Y + C | 1.5 + 5 | 96.3 |

Specifically, table 2 sets out example combinations for filters, wherein a row in the table represents an example filter combination. The first column specifies the material used for the dielectric layer; the second column sets out an (approximate) refractive index value for the dielectric material; the third column specifies the dielectric layer thickness for the example filter design; the fourth column specifies a transmission of the dielectric for radiation with a wavelength of 13.5 nm; the fifth column specifies the material used for the absorber layer of the filter; the sixth column specifies the absorber layer thickness; and the seventh column specified a transmission of the absorber for radiation with a wavelength of 13.5 nm. Any of these example filters can be combined with a mirror layer with a thickness and material selected according to the examples and skin-depth options described above. The dielectric materials with associated thicknesses of any row of table 2 may be mixed with absorber materials with associated thicknesses of the same or any other row of table 2.

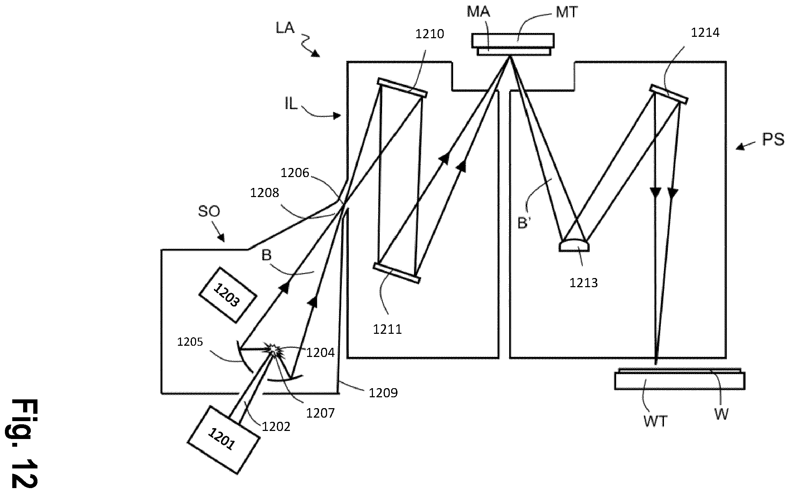

Figure 12 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 1210 and a facetted pupil mirror device 1211. The faceted field mirror device 1210 and faceted pupil mirror device 1211 together provide the EUV radiation beam B with a desired cross-sectional shape and a desired intensity distribution. The illumination system IL may include other mirrors or devices in addition to, or instead of, the faceted field mirror device 1210 and faceted pupil mirror device 1211.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 1213, 1214 in Figure 12, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 12 is, for example, of a type which may be referred to as a laser produced plasma (LPP) source. A laser system 1201, which may, for example, include a CO2 laser or a 1um laser, is arranged to deposit energy via a laser beam 1202 into a fuel, such as tin (Sn) which is provided from, e.g., a fuel emitter 1203. Although tin is referred to in the following description, any suitable fuel may be used. The fuel may, for example, be in liquid form, and may, for example, be a metal or alloy. The fuel emitter 1203 may comprise a nozzle configured to direct tin, e.g. in the form of droplets, along a trajectory towards a plasma formation region 1204. The laser beam 1202 is incident upon the tin at the plasma formation region 1204. The deposition of laser energy into the tin creates a tin plasma 1207 at the plasma formation region 1204. Radiation, including EUV radiation, is emitted from the plasma 1207 during de-excitation and recombination of electrons with ions of the plasma.

The EUV radiation from the plasma is collected and focused by a collector 1205. Collector 1205 comprises, for example, a near-normal incidence radiation collector 1205 (sometimes referred to more generally as a normal-incidence radiation collector). The collector 1205 may have a multilayer mirror structure which is arranged to reflect EUV radiation (e.g., EUV radiation having a desired wavelength such as 13.5 nm). The collector 1205 may have an ellipsoidal configuration, having two focal points. A first one of the focal points may be at the plasma formation region 4, and a second one of the focal points may be at an intermediate focus 1206, as discussed below.

The laser system 1201 may be spatially separated from the radiation source SO. Where this is the case, the laser beam 1202 may be passed from the laser system 1 to the radiation source SO with the aid of a beam delivery system (not shown) comprising, for example, suitable directing mirrors and/or a beam expander, and/or other optics. The laser system 1201, the radiation source SO and the beam delivery system may together be considered to be a radiation system.

Radiation that is reflected by the collector 1205 forms the EUV radiation beam B. The EUV radiation beam B is focused at intermediate focus 1206 to form an image at the intermediate focus 1206 of the plasma present at the plasma formation region 1204. The image at the intermediate focus 1206 acts as a virtual radiation source for the illumination system IL. The radiation source SO is arranged such that the intermediate focus 1206 is located at or near to an opening 1208 in an enclosing structure 1209 of the radiation source SO.

In one example, the radiation filter 800 or 1100 of the present invention is comprised in the lithography apparatus LA. The radiation filter 800 or 1100 may be located at intermediate focus 1206 to reduce the amount to radiation laser from the laser system 1201 into the illumination system IL. Advantageously, the reduction of radiation avoids the overheating of the elements of the illumination system IL and projection system PS. This overheating may provoke optical aberrations in the patterned EUV radiation beam B' which in turn creates patterning defects during the lithography process in the wafer W. Additionally or alternatively, the radiation filter 800 or 1100 may be located between the last mirror 1214 of the projection system PS and the wafer W. Advantageously, this embodiment reduces the amount to radiation laser from the laser system 1201 into the wafer W which may unintentionally heat the wafer W. The wafer overheating creates wafer deformations which are translated on patterning defects during the lithography process.

Although Figure 12 depicts the radiation source SO as a laser produced plasma (LPP) source, any suitable source such as a discharge produced plasma (DPP) source or a free electron laser (FEL) may be used to generate EUV radiation.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Although specific reference may have been made above to the use of embodiments of the invention in the context of optical lithography, it will be appreciated that the invention, where the context allows, is not limited to optical lithography and may be used in other applications, for example imprint lithography.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

Illustrative examples of the technologies disclosed herein are provided below. An embodiment of the technologies may include any one or more, and any combination of, the examples described below.

Example 1 comprises a radiation filter configured to filter a radiation beam comprising a plurality of wavelengths, the filter comprising:
a first material and a second material, the second material having a higher transmission for a first wavelength radiation than the second material.

Example 2 includes the subject matter of Example 1, wherein the first material and the second material are spatially arranged such that rays of the radiation incident on the filter is configured to be transmitted through both materials.

Example 3 includes the subject matter of any of the Examples 1 and 2, wherein the first material and the second material are arranged in a vertical stack.

Example 4 includes the subject matter of any of the Examples 1 to 3, wherein the radiation filter further comprises a third material.

Example 5 includes the subject matter of any of the Examples 1 to 4, wherein the filter is a Salisbury screen.

Example 6 includes the subject matter of any of the Examples 1 to 5, wherein the first material is zirconium.

Example 7 includes the subject matter of any of the Examples 1 to 6, wherein the second material is germanium.

Example 8 includes the subject matter of the Example 4, wherein the third material is carbon.

Example 9 includes the subject matter of the Example 8, wherein the carbon is graphite or amorphous carbon.

Example 10 includes the subject matter of the Example 4, wherein the third material is manganese.

Example 11 includes the subject matter of any of the Examples 1 to 10, wherein the first wavelength radiation comprises a wavelength of 1 µm, or one or more wavelengths in a range of 200 nm to 3000 nm, or optionally one or more wavelengths in a range of 500 nm to 1500 nm, or optionally a wavelength of 1030 nm.

Example 12 includes the subject matter of any of the Examples 1 to 11, wherein the second wavelength radiation comprises one or more wavelengths in a range of 5 nm to 20 nm.

Example 12 includes the subject matter of any of the Examples 1 and 2, wherein and the second material configured to change a phase of the first wavelength radiation; wherein the first material and second material are arranged in a lateral distribution along a surface of the filter, and such that the first wavelength radiation transmitted through the first material and first wavelength radiation transmitted through the second material interfere destructively.

Example 13 comprises a metrology or an inspection apparatus including the radiation filter comprised subject matter of any of the Examples 1 to 12.

Example 14 comprises a lithography apparatus including the radiation filter comprised subject matter of any of the Examples 1 to 12.

## Claims

1. A radiation filter configured to filter a radiation beam comprising a plurality of wavelengths, the filter comprising:
a first material and a second material, the second material having a higher transmission for a first wavelength radiation than the first material, and the second material configured to change a phase of the first wavelength radiation;
wherein the first material and second material are arranged in a lateral distribution along a surface of the filter, and such that the first wavelength radiation transmitted through the first material and first wavelength radiation transmitted through the second material interfere destructively.

2. A radiation filter according to claim 1, wherein the first material has a higher transmission for a second wavelength radiation than for the first wavelength radiation.

3. A radiation filter according to any of the preceding claims, wherein the first material has a first thickness and the second material has a second thickness, and wherein the thickness of the second material is such that the phase change introduced in the first wavelength radiation is an odd multiple of π compared to the phase of the first wavelength radiation transmitted through the first material.

4. A radiation filter according to any of the preceding claims, wherein the first material covers a first portion P1 of the surface of the filter and has a first transmission TD1 for the first wavelength radiation, and the second material covers a second portion P2 of the surface of the filter and has a second transmission TD2 for the first wavelength radiation, such that the ratio of the first and second portions is approximately equal to the ratio of second and first transmissions P1/P2 ≅ TD2/TD1.

5. A radiation filter according to any of the preceding claims, wherein the lateral distribution comprises a periodic distribution of the first material and the second material.

6. A radiation filter according to any of the preceding claims, wherein the lateral distribution is configured such that rays of radiation incident on the filter are transmitted either through the first material or through the second material.

7. A radiation filter according to any of the preceding claims, wherein the first wavelength radiation comprises one or more wavelengths in a range of 200 nm to 3000 nm, and optionally one or more wavelengths in a range of 500 nm to 1500 nm, and optionally a wavelength of 1030 nm, and wherein the second wavelength radiation comprises one or more wavelengths in a range of 0.1 nm - 20 nm, or in a range of 6 nm to 25 nm, or in a range of 9 nm to 18 nm.

8. A radiation filter according to any of the preceding claims, wherein the second radiation is generated from the first wavelength radiation through high harmonic generation.

9. A radiation filter according to any of the preceding claims, wherein the first material comprises zirconium Zr.

10. A radiation filter according to any of the preceding claims, wherein the first material comprises a plurality of layers, wherein the first material comprises a layer of at least one of silver Ag, gold Au, aluminium Al, or copper Cu, and optionally wherein the layer has a thickness in a range of 5 nm to 20 nm, or wherein the first material comprises a layer of at least one of zirconium Zr or graphite.

11. A radiation filter according to any of the preceding claims, wherein the second material has a higher refractive index for the first wavelength radiation than the first material.

12. A radiation filter according to any of the preceding claims, wherein the filter comprises a plurality of second materials.

13. A radiation source comprising a filter according to any of claims 1-12.

14. A metrology apparatus comprising a radiation source according to claim 13.

15. An inspection apparatus comprising a radiation source according to claim 13.
